# DEMANDE DE BREVET EUROPEEN

(11) **EP 4 439 326 A1**
(43) Date de publication de la demande: **02.10.2024**
(21) Numéro de dépôt: 24165867.3
(22) Date de dépôt: 25.03.2024
(51) Int. Cl.: G06F 15/78

(54) **UNITE DE CALCUL D'UN CIRCUIT INTEGRE CONFIGURABLE DESTINEE A AMELIORER LA GESTION D'UN FLUX DE DONNEES**

(30) Priorité: 30.03.2023 FR 2303108
(71) Demandeur: Airbus Operations (S.A.S.), 31060 Toulouse Cedex 9 (FR)
(72) Inventeur: MAURERE, Pascal, 31060 TOULOUSE (FR); CALDEIRA, Anthony, 31060 TOULOUSE (FR)
(74) Mandataire: Cabinet Le Guen Maillet

(57) **Abrégé**

Une unité de calcul (CU) d'un circuit intégré configurable comporte une entrée (10) recevant des données, une sortie (11), et un coeur (100) configuré pour exécuter une opération à partir d'au moins une donnée afin d'obtenir un résultat, et transmettre le résultat vers la sortie (11). L'unité (CU) comporte en outre une mémoire (12) de type First In First Out associée à chaque entrée (10) et configurée pour stocker chaque donnée reçue par ladite entrée. L'unité (CU) déclenche le stockage d'une donnée lorsqu'un signal de validité d'une valeur prédéfinie est détecté, transmet au coeur (100) une donnée stockée et déclenche une exécution de l'opération lorsqu'une donnée est stockée dans chaque mémoire (12) et lorsqu'aucune exécution de l'opération n'est en cours. L'unité (CU) transmet sur la sortie un signal de validité de la valeur prédéfinie simultanément à chaque résultat transmis, et différent sinon.

La gestion de la synchronisation et la stabilisation des données d'entrée est ainsi facilitée.

## Description

### DOMAINE TECHNIQUE

La présente invention concerne le domaine des circuits intégrés configurables et concerne plus particulièrement une unité de calcul d'un tel circuit intégré configurable.

### ETAT DE LA TECHNIQUE ANTERIEURE

Les circuits intégrés configurables ou programmables, tels que les FPGA (« Field-Programmable Gate Array » en anglais), sont de plus en plus utilisés pour réaliser des calculs complexes et notamment pour des opérations de traitement du signal. En aéronautique, leur consommation réduite par rapport à des micro-processeurs et leur flexibilité de configuration les rendent particulièrement intéressants pour la conception de calculateurs avioniques.

La réalisation d'un calcul complexe par un tel circuit intégré configurable est effectuée par un flux de données (« data flow » en anglais), autrement dit par un ensemble d'unités de calcul (« Computational Unit » en anglais). Chaque unité de calcul est capable d'exécuter une opération prédéfinie, telle qu'une fonction mathématique, à partir d'une ou plusieurs données d'entrée et de transmettre en sortie un résultat obtenu par l'exécution de l'opération prédéfinie.

En outre, les unités de calculs du flux de données sont interconnectées entre elles selon une séquence prédéfinie. Le terme séquence prédéfinie désigne ici que les unités de calcul sont organisées de manière prédéfinie et placées successivement et/ou parallèlement les unes par rapport aux autres. Ainsi, un résultat obtenu par une unité de calcul est automatiquement transmis à une unité de calcul suivante de la séquence prédéfinie, ladite unité de calcul suivante utilisant alors ledit résultat comme donnée d'entrée. En outre, une unité de calcul de la séquence prédéfinie peut faire appel simultanément à plusieurs données d'entrée issues chacune d'une unité de calcul précédente distincte, lesdites unités de calcul précédentes étant placées en parallèle.

Par exemple, deux premières unités de calcul sont placées en parallèle l'une de l'autre et précèdent immédiatement une troisième unité de calcul. Selon cet exemple, les résultats obtenus par chacune des premières unités de calcul sont transmis indépendamment l'un de l'autre à la troisième unité de calcul de sorte que l'opération prédéfinie de la troisième unité de calcul est exécutée à partir desdits résultats utilisés simultanément comme données d'entrée.

L'ensemble d'unités de calcul interconnectées du flux de données permet ainsi d'implémenter une opération complexe constituée des opérations prédéfinies selon la séquence prédéfinie.

Une problématique importante de la gestion de flux de données concerne la stabilité des données d'entrée. Il est en effet nécessaire qu'une donnée d'entrée ne varie pas, i.e. ne soit pas remplacée par une autre donnée d'entrée, pendant toute l'exécution de l'opération prédéfinie par une unité de calcul. Par exemple, pour des première et deuxième unités de calcul se succédant, dans l'ordre, si un résultat obtenu par la première unité de calcul est transmis à la deuxième unité de calcul alors que ladite deuxième unité de calcul est en cours d'exécution d'une opération, la donnée d'entrée de la deuxième unité de calcul varie, ce qui risque de générer un résultat erroné, par exemple faux, anormal ou manquant.

Par ailleurs, lorsque la séquence prédéfinie d'un flux de données comporte des unités de calcul utilisées parallèlement, il est en outre nécessaire de synchroniser les différentes données d'entrée d'une unité de calcul, afin d'assurer la stabilité de toutes les données d'entrée simultanément, pendant toute la durée de l'exécution de l'opération prédéfinie.

Une première solution est d'insérer un délai entre deux unités de calcul successives, par exemple à l'aide d'un registre à décalage. L'insertion d'un tel délai permet de générer un retard entre l'obtention d'un résultat par une unité de calcul et sa réception comme donnée d'entrée par l'unité de calcul suivante et donc de gérer la stabilité et la synchronisation des données d'entrée de l'unité de calcul suivante. En calibrant de manière adéquate la durée de ce délai, il est assuré que les données d'entrée attendues sont correctement placées en entrée de l'unité de calcul en question pendant toute l'exécution de ladite opération prédéfinie devant être réalisée à partir desdites données d'entrée. Une telle solution est néanmoins coûteuse en termes de ressources alors que les ressources disponibles dans un circuit intégré configurable sont relativement limitées.

Une deuxième solution est de définir un instant de déclenchement pour l'exécution de l'opération prédéfinie de chaque unité de calcul. L'instant de déclenchement pour une première unité de calcul est déterminé en tenant compte d'un instant ultérieur auquel est attendue une donnée d'entrée en entrée d'une unité de calcul immédiatement suivante et de la durée d'exécution de l'opération prédéfinie de la première unité de calcul. Lorsque plusieurs premières unités de calcul sont placées en parallèle dans la séquence prédéfinie, l'instant de déclenchement de chacune desdites premières unités de calcul est ainsi déterminé de sorte que les résultats fournis sont reçus en même temps, comme données d'entrée, à l'entrée de l'unité de calcul immédiatement suivante. L'instant de déclenchement de chaque unité de calcul de la séquence prédéfinie peut ainsi être prédéterminé de proche en proche, pour chaque unité de calcul, en partant de la fin de la séquence prédéfinie. Un orchestrateur permet de gérer les instants de déclenchement prédéterminés de chaque unité de calcul de la séquence prédéfinie. La stabilité et la synchronisation des données d'entrée sont ainsi gérées par les déclenchements successifs, par l'orchestrateur, de l'exécution des opérations prédéfinies des unités de calcul.

Toutefois, de telles solutions nécessitent de déterminer une durée d'exécution effective de chaque opération prédéfinie des unités de calcul du flux de données afin d'implémenter précisément les délais insérés ou les instants de déclenchements. La configuration du flux de données s'en trouve alors complexifiée. En outre, la flexibilité et la facilité de maintenance du flux de données sont réduites en cas de modification d'une ou plusieurs opérations prédéfinies et/ou de la séquence prédéfinie.

Par ailleurs, aucune desdites solutions ne permet d'optimiser l'utilisation d'une unité de calcul en termes de durée d'utilisation. En effet, que ce soit en raison de l'insertion de délais ou de l'implémentation d'instants de déclenchement, les unités de calcul doivent attendre entre deux exécutions successives d'une opération prédéfinie, et ne sont donc pas exploitées pendant une telle attente.

Il est alors souhaitable de pallier ces inconvénients de l'état de la technique.

Il est notamment souhaitable de fournir une solution qui permette de configurer un flux de données pour lequel la synchronisation et la stabilisation des données d'entrée est facile à implémenter, flexible et facile à maintenir. Il est en outre souhaitable de fournir une solution qui permette d'optimiser les ressources matérielles et notamment de maximiser la durée d'utilisation d'une unité de calcul, tout en minimisant la durée effective de l'opération complexe implémentée globalement par le flux de données.

### EXPOSE DE L'INVENTION

Un objet de la présente invention est de proposer une unité de calcul d'un circuit intégré configurable. L'unité de calcul comporte : au moins une entrée, configurée pour recevoir des données incidentes ; une sortie ; un coeur situé entre la au moins une entrée et la sortie et configuré pour exécuter une opération prédéfinie à partir d'au moins une donnée d'entrée afin d'obtenir un résultat, et pour transmettre le résultat obtenu vers la sortie. L'unité de calcul comporte en outre : une mémoire tampon de type First In First Out, dite mémoire de réception, associée à chaque entrée et configurée pour stocker chaque donnée incidente reçue par ladite entrée. L'unité de calcul est configurée pour détecter un signal de validité reçu sur ladite au moins une entrée et déclencher le stockage, par la mémoire de réception associée à l'entrée en question, d'une donnée incidente lorsque le signal de validité détecté est égal à une valeur prédéfinie, pour transmettre au coeur, en tant que donnée d'entrée, une donnée stockée dans chaque mémoire de réception, et déclencher une exécution de l'opération prédéfinie lorsqu'au moins une donnée est stockée dans chaque mémoire de réception de l'unité de calcul, et lorsqu'en outre aucune exécution de l'opération prédéfinie n'est en cours et pour transmettre sur la sortie un signal de validité égal à la valeur prédéfinie simultanément à la transmission de chaque résultat obtenu, et transmettre un signal de validité différent de la valeur prédéfinie sinon.

La stabilité et la synchronisation des données d'entrée sont donc gérées aisément et de manière autonome et indépendante pour l'unité de calcul. Il est en outre possible de traiter plusieurs voies de données tout en optimisant les ressources matérielles utilisées pour implémenter un flux de données. Le fait d'avoir une mémoire tampon de type First In First Out associée à chaque entrée permet de recevoir des flux de données de façon totalement indépendante et asynchrone sur les différentes entrées de l'unité de calcul, sans risque de perdre une donnée reçue sur une entrée.

Selon un mode de réalisation particulier, l'unité de calcul est configurée en outre pour associer un identifiant à chaque résultat transmis, ledit identifiant étant l'identifiant associé à la donnée incidente à partir de laquelle ledit résultat transmis est obtenu.

Selon un mode de réalisation particulier, l'unité de calcul est configurée de telle sorte que l'identifiant associé à chaque résultat transmis est concaténé avec le résultat transmis.

Selon un mode de réalisation particulier, l'unité de calcul est configurée en outre de telle sorte qu'aucune exécution de l'opération prédéfinie n'est en cours lorsqu'une exécution immédiatement précédente de l'opération prédéfinie est terminée et que le résultat fourni par ladite exécution précédente est transmis vers la sortie.

Selon un mode de réalisation particulier, l'unité de calcul est configurée de telle sorte que l'identifiant associé à chaque donnée incidente est un identifiant d'une voie à laquelle appartient ladite donnée incidente, une voie étant un ensemble de données utilisées par un ensemble d'unités de calcul pour obtenir un même résultat final à partir d'un jeu de données initial, et l'identifiant associé à chaque résultat transmis est l'identifiant de la voie à laquelle appartient le résultat.

L'invention concerne également un circuit intégré configurable comportant un ensemble d'unités de calcul dans l'un quelconque des modes de réalisation. Lesdites unités de calcul sont interconnectées entre elles selon une séquence prédéfinie de telle sorte que, en considérant une première unité de calcul dont la sortie est connectée à une entrée d'une deuxième unité de calcul qui suit la première unité de calcul selon la séquence prédéfinie, le résultat et le signal de validité transmis par le coeur vers la sortie de la première unité de calcul sont automatiquement transmis à l'entrée de la deuxième unité de calcul.

Selon un mode de réalisation particulier, la connexion entre la sortie d'une unité de calcul et l'entrée de l'unité de calcul suivante selon la séquence prédéfinie est implémentée par un bus de communication configuré pour transmettre le résultat en association avec un identifiant et pour transmettre le signal de validité.

L'invention concerne également un aéronef comportant un tel circuit intégré configurable.

L'invention concerne également un procédé implémenté par une unité de calcul d'un circuit intégré configurable. L'unité de calcul comporte : au moins une entrée, configurée pour recevoir des données incidentes ; une sortie ; un coeur situé entre la au moins une entrée et la sortie et configuré pour exécuter une opération prédéfinie à partir d'au moins une donnée d'entrée afin d' obtenir un résultat, et pour transmettre le résultat obtenu vers la sortie. L'unité de calcul comporte en outre une mémoire tampon de type First In First Out, dite mémoire de réception, associée à chaque entrée et configurée pour stocker chaque donnée incidente reçue par ladite entrée. Le procédé comporte les étapes suivantes, implémentées par l'unité de calcul : détecter un signal de validité reçu sur ladite au moins une entrée et déclencher le stockage, par la mémoire de réception associée à l'entrée en question, d'une donnée incidente lorsque le signal de validité détecté est égal à une valeur prédéfinie ; transmettre au coeur, en tant que donnée d'entrée, une donnée stockée dans chaque mémoire de réception, et déclencher une exécution de l'opération prédéfinie lorsqu'au moins une donnée est stockée dans chaque mémoire de réception de l'unité de calcul, et lorsqu'en outre aucune exécution de l'opération prédéfinie n'est en cours ; et transmettre sur la sortie un signal de validité égal à la valeur prédéfinie simultanément à la transmission de chaque résultat obtenu, et transmettre un signal de validité différent de la valeur prédéfinie sinon.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1A] illustre schématiquement une unité de calcul d'un circuit intégré configurable selon un mode de réalisation particulier ;
[Fig. 1B] illustre schématiquement une unité de calcul d'un circuit intégré configurable selon un autre mode de réalisation particulier ;
[Fig. 2A] illustre schématiquement un premier algorithme implémenté par l'unité de calcul ;
[Fig. 2B] illustre schématiquement un deuxième algorithme implémenté par l'unité de calcul ;
[Fig. 3A] illustre schématiquement un flux de données comportant un ensemble d'unités de calcul, selon un premier mode de réalisation ;
[Fig. 3B] illustre schématiquement un flux de données comportant un ensemble d'unités de calcul, selon un deuxième mode de réalisation ;
[Fig. 4] illustre schématiquement un aéronef comportant un circuit intégré configurable ;
[Fig. 5] illustre schématiquement un premier exemple d'un chronogramme représentant l'exécution d'une opération globale par le flux de données du premier mode de réalisation ; et
[Fig. 6] illustre schématiquement un deuxième exemple d'un chronogramme représentant l'exécution d'une opération globale par le flux de données du deuxième mode de réalisation.

### EXPOSE DETAILLE DE MODES DE REALISATION

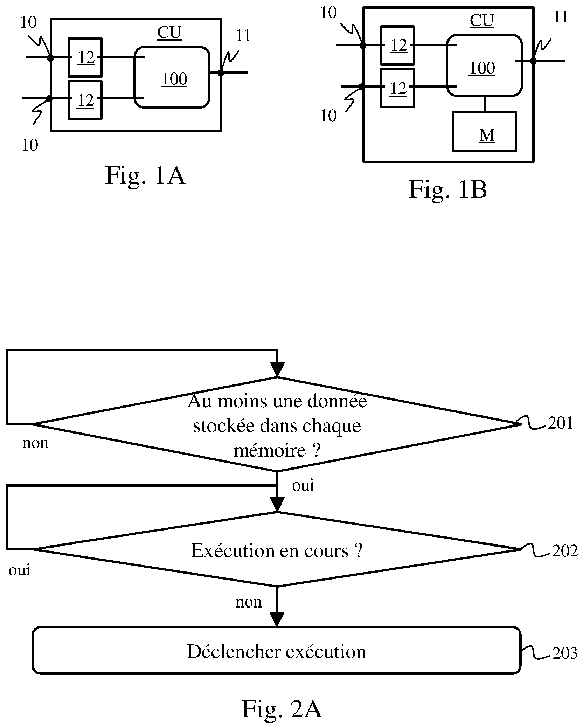

La **Fig. 1A** illustre ainsi schématiquement une unité de calcul CU (« Computational Unit » en anglais) d'un circuit intégré configurable, tel qu'un FPGA (« Field-Programmable Gate Array » en anglais), un CPLD (« Complex Programmable Logic Device » en anglais) ou un ASIC (« Application-Specific Integrated Circuit » en anglais), selon un mode de réalisation particulier.

L'unité de calcul CU comporte un coeur 100 configuré pour exécuter (i.e., implémenter) une opération prédéfinie, telle qu'un calcul ou une fonction mathématique, à partir d'un jeu de données d'entrée de sorte à obtenir un résultat. Le coeur 100 est par exemple un circuit logique. Selon un autre exemple, le coeur 100 est une puce de microprocesseur intégrée au circuit intégré configurable. L'unité de calcul CU comporte au moins une entrée 10 et une sortie 11. Dans le mode de réalisation illustré en Fig. 1A, l'unité de calcul CU comporte deux entrées 10.

L'unité de calcul CU est configurée pour recevoir, au niveau de chaque entrée 10, des données incidentes. Chaque exécution de l'opération prédéfinie par le coeur 100 est effectuée à partir d'un jeu de données comportant une donnée d'entrée pour chaque entrée 10. L'unité de calcul CU est en outre configurée pour émettre, au niveau de la sortie 11, le résultat obtenu.

L'unité de calcul CU comporte en outre une mémoire tampon (ou « buffer » en anglais), dite mémoire de réception 12, associée à chaque entrée 10. Chaque mémoire de réception 12 est configurée pour stocker toute donnée incidente reçue par l'entrée associée.

Selon un mode de réalisation, chaque donnée incidente est associée à un identifiant. Préférentiellement, ledit identifiant permet d'identifier une voie, ou canal (« channel » en anglais), à laquelle ladite donnée incidente appartient. Une voie correspond, au niveau de l'unité de calcul CU, au jeu de données d'entrée utilisé en vue d'obtenir un même résultat. Selon un mode de réalisation particulier, chaque donnée incidente est reçue par l'unité de calcul CU sous forme d'une unique chaîne de caractères comprenant une concaténation de la donnée incidente et de l'identifiant associée. Dans l'expression « chaîne de caractères », le terme « caractères » n'est pas limité à des caractères alphanumériques. Il inclut tous types de données, qu'elles soient de type numérique (selon tout codage possible), alphanumérique ou autre.

L'unité de calcul CU comporte de la circuiterie électronique, configurée pour détecter un signal de validité reçu sur l'entrée 10. La circuiterie électronique est en outre configurée pour déclencher le stockage, par la mémoire de réception 12, d'une donnée incidente lorsque le signal de validité détecté est égal à une valeur prédéfinie. Dit autrement, chaque mémoire de réception 12 effectue le stockage d'une nouvelle donnée seulement lorsque le signal de validité détecté est égal à ladite valeur prédéfinie.

La circuiterie électronique est en outre configurée pour transmettre sur la sortie 11, et parallèlement à chaque résultat transmis, un signal de validité égal à la valeur prédéfinie de manière simultanée avec la transmission dudit résultat. La circuiterie électronique est configurée en outre pour modifier la valeur du signal de validité après la transmission de chaque résultat, par exemple après l'écoulement d'une durée prédéterminée suivant la transmission de chaque résultat, de sorte à transmettre sur la sortie 11 un signal de validité différent de la valeur prédéfinie. Dit autrement, le signal de validité transmis a une valeur égale à la valeur prédéfinie au moment où le résultat est transmis, ladite valeur étant maintenue pendant la durée prédéterminée, puis la valeur du signal de validité est modifiée après l'écoulement de la durée prédéterminée. Par exemple, le signal de validité est un signal encodé sur 1 bit et est fixé à 1 lorsqu'un résultat est transmis et fixé à zéro sinon.

Selon un mode de réalisation, la circuiterie électronique est en outre configurée pour associer un identifiant à chaque résultat obtenu. L'identifiant associé à un résultat est l'identifiant de la voie à laquelle appartient le jeu de données d'entrée ayant permis d'aboutir audit résultat par l'exécution de l'opération prédéfinie. Dit autrement, l'identifiant associé au résultat est l'identifiant associé à la donnée incidente à partir de laquelle ledit résultat est obtenu. Pour cela, l'unité de calcul CU capture l'identifiant associé à chaque donnée incidente reçue et stockée et sauvegarde ledit identifiant pendant que le coeur 100 exécute l'opération prédéfinie à partir de ladite donnée incidente. Lorsque ladite exécution de l'opération prédéfinie est terminée, l'unité de calcul CU associe alors au résultat obtenu l'identifiant capturé.

Selon un mode de réalisation particulier, l'unité de calcul CU associe un identifiant à un résultat obtenu par concaténation du résultat obtenu et de l'identifiant, de sorte à former une unique chaîne de caractères.

L'unité de calcul CU comporte de la circuiterie électronique, configurée pour déclencher, à deux conditions, une exécution de l'opération prédéfinie par le coeur 100, en récupérant une donnée stockée dans la mémoire de réception 12 de chaque entrée 10 et en transmettant chaque donnée récupérée, comme donnée d'entrée, au coeur 100.

La première condition est qu'aucune exécution de l'opération prédéfinie ne doit être en cours. Ainsi, lorsqu'une nouvelle donnée incidente est reçue par une entrée 10 de l'unité de calcul CU, ladite nouvelle donnée incidente est stockée dans la mémoire de réception associée sans entraîner de changement de la donnée d'entrée utilisée par le coeur. La stabilité des données d'entrée utilisées par le coeur 100 est ainsi garantie. En outre, lorsqu'une exécution de l'opération prédéfinie se termine, autrement dit lorsqu'un résultat est obtenu et transmis vers la sortie 11, une nouvelle donnée d'entrée est transmise depuis la mémoire de réception 12 au coeur 100 par l'unité de calcul CU afin de déclencher automatiquement une nouvelle exécution de l'opération prédéfinie.

La deuxième condition est que la mémoire de réception 12 de chaque entrée 10 doit comporter au moins une donnée stockée. Ainsi, chaque unité de calcul CU peut gérer de manière autonome la synchronisation des données sur ses différentes entrées 10. Une exécution de l'opération prédéfinie ne peut donc par exemple pas être déclenchée si une donnée incidente a été reçue sur une seule entrée 10 alors que l'unité de calcul CU comporte deux entrées ou plus. La synchronisation des données d'entrée est alors garantie.

Le déclenchement d'une exécution de l'opération prédéfinie selon lesdites deux conditions permet en outre à l'unité de calcul CU d'exécuter la même opération prédéfinie à plusieurs reprises consécutivement. Dit autrement, aucun délai d'attente n'est nécessaire entre deux exécutions successives de l'opération prédéfinie (e.g., deux calculs successifs) pour garantir la stabilité et la synchronisation des données d'entrée sur l'unité de calcul CU, dans la mesure où l'ensemble des données d'entrée nécessaires à l'exécution de l'opération prédéfinie sont disponibles (i.e., stockées dans la mémoire de réception 12).

L'unité de calcul CU peut en outre effectuer deux exécutions successives de l'opération prédéfinie pour deux voies distinctes. L'unité de calcul CU est ainsi configurée pour gérer aisément une pluralité de voies en les traitant successivement. L'absence de délais d'attente permet de maximiser la durée d'utilisation de l'unité de calcul CU et permet ainsi d'optimiser l'utilisation de ressources matérielles dans un circuit intégré configurable.

Chaque mémoire de réception 12 est une mémoire de type FIFO (pour « First In First Out » en anglais). Les données incidentes sont stockées puis récupérées par l'unité de calcul CU dans l'ordre dans lequel lesdites données incidentes sont reçues au niveau de l'entrée 10 associée. Ainsi, lorsque plusieurs données incidentes sont reçues successivement sur la même entrée 10, l'unité de calcul CU sélectionne automatiquement la donnée incidente reçue la plus ancienne. Le fait d'avoir une mémoire tampon de type First In First Out associée à chaque entrée permet de recevoir des flux de données de façon totalement indépendante et asynchrone sur les différentes entrées de l'unité de calcul, sans risque de perdre une donnée reçue sur une entrée. De plus, lorsqu'une sortie d'une première unité de calcul est reliée à une entrée d'une deuxième unité de calcul, la première unité de calcul peut placer sur sa sortie un résultat d'un calcul qu'elle a réalisé dès la fin du calcul, sans attendre un délai ou une disponibilité de l'entrée de la deuxième unité de calcul. En effet, une mémoire tampon de type First In First Out étant associée à la deuxième entrée, cela garantit que le résultat du calcul peut être reçu à tout instant, de façon totalement indépendante de la réception d'autres données sur d'autre(s) entrée(s) de la deuxième unité de calcul et de façon totalement indépendante de la disponibilité de la deuxième unité de calcul. Par conséquent, cela permet de réduire les temps de latence pour l'enchaînement d'un ensemble de calculs par différentes unités de calcul interconnectées dans le circuit intégré.

La **Fig. 1B** illustre schématiquement une unité de calcul CU d'un circuit intégré configurable selon un autre mode de réalisation particulier. Selon l'autre mode de réalisation particulier, l'unité de calcul CU comporte, outre la au moins une entrée 10, la sortie 11, le coeur 100 et la au moins une mémoire de réception 12, au moins une mémoire de travail additionnelle M.

La mémoire de travail additionnelle M permet de stocker (i.e., enregistrer) des données d'entrée utilisées préalablement pour exécuter l'opération prédéfinie et appartenant à plusieurs voies distinctes. Chaque donnée d'entrée est enregistrée en association avec l'identifiant de la voie concernée. Ainsi, le coeur 100 de l'unité de calcul peut exécuter une opération prédéfinie plus complexe, tel qu'un produit de convolution, faisant appel à des données appartenant à plusieurs voies, tout en gérant aisément une pluralité de voies. Par exemple, un produit de convolution exécuté par le coeur 100 de l'unité de calcul CU fait appel à des données appartenant à plusieurs voies ainsi qu'à des coefficients. Lesdits coefficients sont stockés dans la mémoire de travail additionnelle M. Alternativement, les coefficients sont stockés dans une deuxième mémoire de travail additionnelle (non représentée). Les coefficients peuvent être les mêmes pour chaque voie et sont alors constants. Alternativement, les coefficients dépendent de la voie pour laquelle le produit de convolution est exécuté.

La **Fig. 2A** illustre schématiquement un premier algorithme implémenté par l'unité de calcul CU.

Dans une première étape 201, l'unité de calcul CU détermine si au moins une donnée est stockée dans chaque mémoire de réception 12 de ladite unité de calcul CU. Si c'est le cas, l'unité de calcul CU passe à une étape 202. Sinon, l'unité de calcul CU retourne à l'étape 201.

A l'étape 202, l'unité de calcul CU détermine si une exécution de l'opération prédéfinie par le coeur 100 est en cours. Si c'est le cas, l'unité de calcul CU retourne à l'étape 202 afin d'attendre que l'exécution en cours de l'opération prédéfinie se termine. Sinon, l'unité de calcul CU passe à une étape 203.

A l'étape 203, l'unité de calcul CU déclenche une exécution de l'opération prédéfinie par le coeur 100. Pour cela, l'unité de calcul CU récupère une donnée stockée dans chaque mémoire de réception pour la transmettre au coeur en tant que donnée d'entrée. Selon un mode de réalisation, la transmission de la donnée d'entrée au coeur 100 déclenche automatiquement l'exécution de l'opération prédéfinie.

L'unité de calcul CU retourne ensuite à l'étape 201.

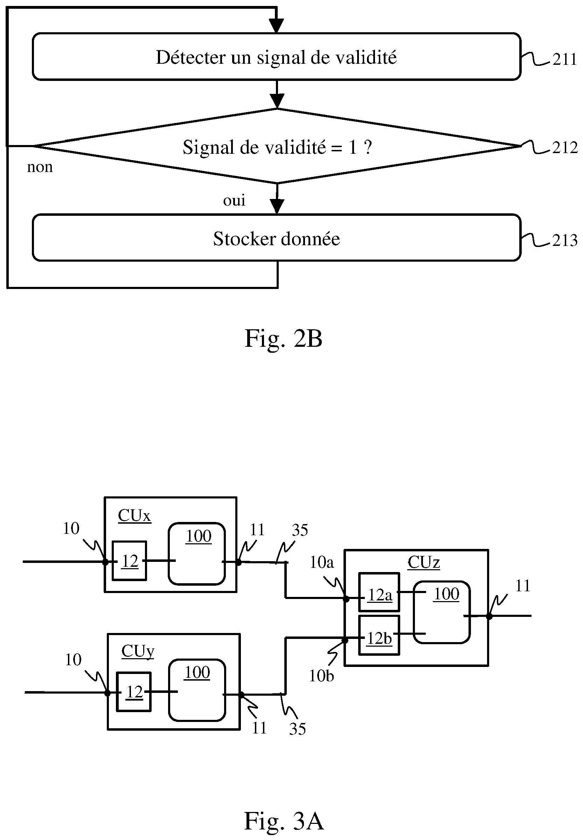

La **Fig. 2B** illustre schématiquement un deuxième algorithme, implémenté par l'unité de calcul CU en parallèle du premier algorithme.

Dans une première étape 211, l'unité de calcul CU détecte un signal de validité reçu sur l'entrée 10.

Dans une étape 212 suivante, l'unité de calcul CU détermine si le signal de validité détecté est égal à la valeur prédéfinie. Si c'est le cas, une étape 213 est effectuée. Sinon, l'unité de calcul CU retourne à l'étape 211.

A l'étape 213, l'unité de calcul CU déclenche le stockage, par la mémoire de réception 12, de la donnée incidente.

La **Fig. 3A** illustre schématiquement un flux de données (« data flow » en anglais) selon un premier mode de réalisation, comportant un ensemble d'unités de calcul CUx, CUy, CUz d'un circuit intégré configurable. Le flux de données permet, à partir d'un jeu de données initial, d'implémenter, ou exécuter, une opération globale afin de fournir un résultat final.

Les unités de calcul CUx, CUy, CUz sont interconnectées entre elles et séquencées selon une séquence prédéfinie, autrement dit organisées de manière prédéfinie et placées successivement et/ou parallèlement les unes par rapport aux autres. Le résultat obtenu par une unité de calcul CU, telle que l'unité de calcul CUx, est automatiquement transmis à une entrée 10 d'une unité de calcul suivante de la séquence prédéfinie, telle que l'unité de calcul CUz, où ledit résultat est alors traité comme donnée incidente par ladite unité de calcul CU suivante. L'opération globale implémentée par le flux de données est ainsi constituée de chaque opération prédéfinie du flux de données, selon la séquence prédéfinie.

Dans le premier mode de réalisation, le flux de données comporte une première unité de calcul CUx, comportant une entrée 10 et une sortie 11, une deuxième unité de calcul CUy comportant une entrée 10 et une sortie 11 et une troisième unité de calcul CUz comportant une première entrée 10a, une deuxième entrée 10b et une sortie 11. Le coeur 100 de la première unité de calcul CUx est configuré pour exécuter une première opération prédéfinie. Similairement, le coeur 100 de la deuxième unité de calcul CUy, respectivement de la troisième unité de calcul CUz, est configuré pour exécuter une deuxième, respectivement troisième, opération prédéfinie. Chaque unité de calcul CUx, CUy, CUz comporte une mémoire de réception 12, 12a, 12b associée à chaque entrée 10, 10a, 10b.

La sortie 11 de la première unité de calcul CUx est reliée, par un lien de communication 35, tel qu'un bus de communication, à la première entrée 10a de la troisième unité de calcul CUz. En d'autres termes, un résultat obtenu par le coeur 100 de la première unité de calcul CUx est automatiquement envoyé, éventuellement en association avec un identifiant de la voie à laquelle appartient le résultat, vers la première entrée 10a de la troisième unité de calcul CUz. En outre, la sortie 11 de la deuxième unité de calcul CUy est reliée, par un lien de communication 35, à la deuxième entrée 10b de la troisième unité de calcul CUz. Un résultat obtenu par le coeur 100 de la deuxième unité de calcul CUy est ainsi automatiquement envoyé vers la deuxième entrée 10a de la troisième unité de calcul CUz. Selon un mode de réalisation particulier, chaque unité de calcul, telle que la première ou la deuxième unité de calcul CUx, CUy, concatène chaque résultat obtenu avec l'identifiant de la voie associée audit résultat, de sorte à former une chaîne de caractères. Le lien de communication 35 transmet la chaîne de caractères ainsi formée à l'unité de calcul suivante, telle que l'unité de calcul CUz, de la séquence prédéfinie.

Chaque unité de calcul CUx, CUy, CUz du flux de données est configurée pour gérer plusieurs voies. Une voie regroupe l'ensemble des données utilisées par les unités de calcul CUx, CUy, CUz du flux de données pour obtenir, à partir d'un jeu de données initial, un résultat final, par l'exécution de l'opération globale. En d'autres termes, une voie correspond à une exécution de l'opération globale. Un identifiant d'une voie est un identifiant d'exécution d'opération globale.

Dans un exemple de mise en oeuvre, l'entrée 10 de l'unité de calcul CUx est reliée à au moins une première source d'information configurée pour lui fournir des données provenant d'au moins un premier capteur, par exemple un capteur d'un aéronef dans lequel est installé le circuit intégré. De même, l'entrée 10 de l'unité de calcul CUy est reliée à au moins une deuxième source d'information configurée pour lui fournir des données provenant d'au moins un deuxième capteur de l'aéronef. Les unités de calcul CUx, CUy et CUz sont configurées pour exécuter au moins une première opération globale pour une première voie et une deuxième opération globale pour une deuxième voie. La première opération globale, correspondant à la première voie, utilise des données provenant d'un premier capteur C1A en entrée de l'unité de calcul CUx et des données provenant d'un deuxième capteur C2A en entrée de l'unité de calcul CUy. Un identifiant de la première voie est associé aux données provenant du capteur C1A reçues en entrée de l'unité de calcul CUx, ainsi qu'aux données provenant du capteur C2A reçues en entrée de l'unité de calcul CUy. L'identifiant de la première voie est aussi associé aux résultats calculés par les unités de calcul CUx et CUy sur la base desdites données d'entrée (provenant respectivement des capteur C1A et C2A). Ces résultats et l'identifiant associé correspondant à la première voie sont transmis vers l'unité de calcul CUz par les liens de communication 35. L'unité de calcul CUz calcule en conséquence un résultat global auquel elle associe également l'identifiant correspondant à la première voie. La deuxième opération globale, correspondant à la deuxième voie, utilise des données provenant d'un autre premier capteur C1B en entrée de l'unité de calcul CUx et des données provenant d'un autre deuxième capteur C2B en entrée de l'unité de calcul CUy. Un identifiant de la deuxième voie est associé aux données provenant du capteur C1B reçues en entrée de l'unité de calcul CUx, ainsi qu'aux données provenant du capteur C2B reçues en entrée de l'unité de calcul CUy. L'identifiant de la deuxième voie est aussi associé aux résultats calculés par les unités de calcul CUx et CUy sur la base desdites données d'entrée (provenant respectivement des capteur C1B et C2B). Ces résultats et l'identifiant associé correspondant à la deuxième voie sont transmis vers l'unité de calcul CUz par les liens de communication 35. L'unité de calcul CUz calcule en conséquence un résultat global auquel elle associe également l'identifiant correspondant à la deuxième voie. Le fait d'utiliser les mêmes unités de calcul CUx, CUy et CUz pour exécuter la première opération globale et pour exécuter la deuxième opération globale permet de réduire le nombre d'unités de calcul du circuit intégré et donc d'optimiser les ressources.

Chaque unité de calcul CUx, CUy, CUz étant capable de gérer, de manière autonome et indépendante, la stabilité et la synchronisation de ses données d'entrée, la gestion du flux de données s'en trouve facilitée, aussi bien lors de la configuration du circuit intégré configurable qu'en cas d'évolution d'au moins une unité de calcul CUx, CUy, CUz et/ou de la séquence prédéfinie. L'évolution d'une unité de calcul CUx, CUy, CUz peut par exemple impliquer une variation d'une durée effective d'exécution de l'opération prédéfinie de ladite unité de calcul CUx, CUy, CUz.

En outre, aucun délai d'attente n'étant nécessaire entre deux exécutions de l'opération prédéfinie de chaque unité de calcul CUx, CUy, CUz, il est aisé de réduire la durée d'exécution de l'opération globale du flux de données, ou de réduire la quantité d'unités de calcul CU (autrement dit de ressources matérielles) utilisées pour exécuter ladite opération globale à durée égale. De même, le nombre de voies traitées peut être augmenté à durée égale et à quantité égale d'unités de calcul utilisées.

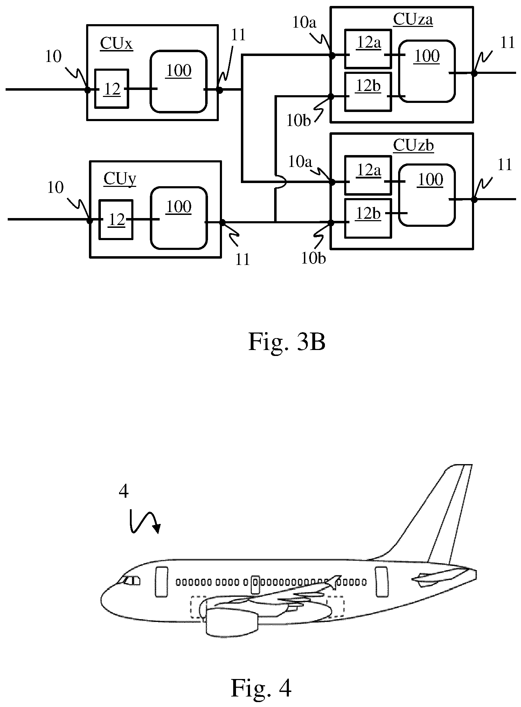

La **Fig. 3B** illustre schématiquement un flux de données (« data flow » en anglais) selon un deuxième mode de réalisation, comportant un ensemble d'unités de calcul CUx, CUy, CUza et CUzb. Dans le deuxième mode de réalisation, le flux de données comporte la première et la deuxième unité de calcul CUx et CUy. La troisième unité de calcul CUz décrite dans le mode de réalisation de la Fig. 3A, est dupliquée, dans le deuxième mode de réalisation, en une troisième unité de calcul CUza et une quatrième unité de calcul CUzb identiques.

La sortie 11 de la première unité de calcul CUx est reliée à la première entrée 10a de la troisième unité de calcul CUza et à la première entrée 10a de la quatrième unité de calcul CUzb. En outre, la sortie 11 de la deuxième unité de calcul CUy est reliée à la deuxième entrée 10b de la troisième unité de calcul CUza et à la deuxième entrée 10b de la quatrième unité de calcul CUzb. Ainsi, un résultat obtenu par le coeur 100 de la première unité de calcul CUx est automatiquement envoyé vers la première entrée 10a de la troisième unité de calcul CUza et/ou vers la première entrée 10a de la quatrième unité de calcul CUzb. Un résultat obtenu par le coeur 100 de la deuxième unité de calcul CUy est ainsi automatiquement envoyé vers la deuxième entrée 10b de la troisième unité de calcul CUza et/ou vers la deuxième entrée 10b de la quatrième unité de calcul CUzb.

Selon un exemple de réalisation, chaque résultat obtenu par le coeur 100 de la première unité de calcul CUx est envoyé soit vers la première entrée 10a de la troisième unité de calcul CUza soit vers la première entrée 10a de la quatrième unité de calcul CUzb en fonction de l'identifiant associé audit résultat. Par exemple, un démultiplexeur est placé après la sortie 11 de la première unité de calcul CUx et comporte une table de correspondance associant à chaque identifiant une unité de calcul CUza ou CUzb parmi la troisième et la quatrième unités de calcul CUza, CUzb. Le démultiplexeur détermine l'identifiant associé à chaque résultat reçu en provenance de la première unité de calcul CUx et en déduit, à l'aide de la table de correspondance, si le résultat doit être transmis à la troisième unité de calcul CUza ou à la quatrième unité de calcul CUzb. Un démultiplexeur similaire est placé après la sortie 11 de la deuxième unité de calcul CUy.

La **Fig. 4** illustre schématiquement un aéronef 4 comportant au moins un circuit intégré configurable comportant un ensemble d'unités de calcul CU.

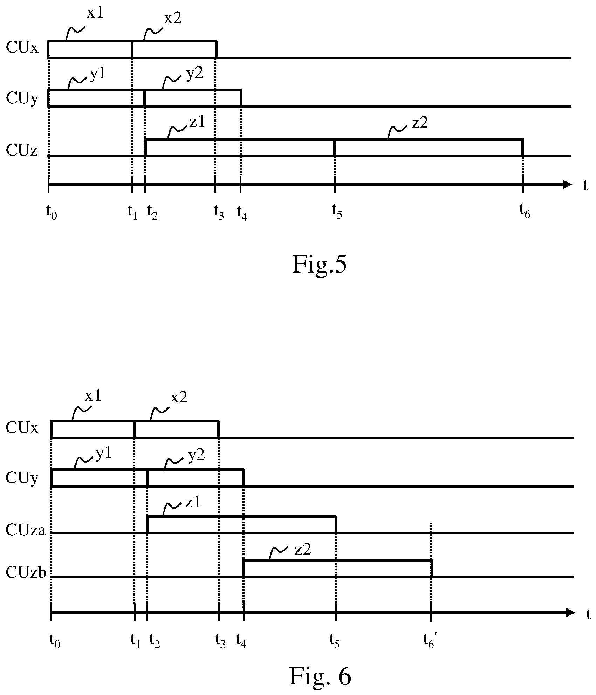

La **Fig. 5** illustre schématiquement un premier exemple d'un chronogramme représentant l'exécution d'une opération globale pour une première voie et une deuxième voie, par le flux de données du premier mode de réalisation.

La première opération prédéfinie, la deuxième opération prédéfinie et la troisième opération prédéfinie ont chacune une durée effective d'exécution propre. Dans le premier exemple de chronogramme, la durée effective d'exécution de la première opération prédéfinie est inférieure à la durée effective d'exécution de la deuxième opération prédéfinie, qui est elle-même inférieure à la durée effective d'exécution de la troisième opération prédéfinie.

Au démarrage du chronogramme, autrement dit, à un instant initial t₀, on considère que la mémoire de réception 12 de la première unité de calcul CUx comporte une donnée d'entrée appartenant à la première voie et une donnée d'entrée appartenant à la deuxième voie. On considère en outre que la mémoire de réception 12 de la deuxième unité de calcul CUy comporte une donnée d'entrée appartenant à la première voie et une donnée d'entrée appartenant à la deuxième voie.

A l'instant initial t₀, la première unité de calcul CUx récupère dans la mémoire de réception 12 associée à son entrée 10, une donnée d'entrée appartenant à la première voie et déclenche une première exécution x1 de la première opération prédéfinie. En outre, la deuxième unité de calcul CUy récupère dans la mémoire de réception 12 associée à son entrée 10, une donnée d'entrée de la première voie et déclenche une première exécution y1 de la deuxième opération prédéfinie.

A un instant t₁, la première unité de calcul CUx termine la première exécution x1 de la première opération prédéfinie et transmet le résultat ainsi obtenu, éventuellement en association avec un identifiant de la première voie, à la troisième unité de calcul CUz. La première unité de calcul CUx affecte alors la valeur prédéfinie à un signal de validité et transmet ledit signal de validité parallèlement et simultanément à la transmission du résultat.

La troisième unité de calcul CUz détecte alors que le signal de validité reçu sur sa première entrée 10a est égal à la valeur prédéfinie. La mémoire de réception 12a associée à la première entrée 10a de la troisième unité de calcul CUz stocke alors ledit résultat, appartenant à la première voie. En outre, la première unité de calcul CUx récupère dans la mémoire de réception 12 associée à son entrée 10, la donnée d'entrée appartenant à la deuxième voie et déclenche une deuxième exécution x2 de la première opération prédéfinie.

A un instant t₂, la deuxième unité de calcul CUy termine la première exécution y1 de la deuxième opération prédéfinie et transmet le résultat ainsi obtenu, éventuellement en association avec l'identifiant de la première voie, à la deuxième entrée 10b de la troisième unité de calcul CUz. La deuxième unité de calcul CUy affecte alors la valeur prédéfinie à un signal de validité et transmet ledit signal de validité parallèlement et simultanément à la transmission du résultat. La troisième unité de calcul CUz détecte alors que le signal de validité reçu sur sa deuxième entrée 10b est égal à la valeur prédéfinie. La mémoire de réception 12 associée à ladite deuxième entrée 10b stocke alors ledit résultat, qui appartient à la première voie. En outre, la deuxième unité de calcul CUy récupère dans la mémoire de réception 12 associée à son entrée 10, une donnée d'entrée de la deuxième voie et déclenche une deuxième exécution y2 de la deuxième opération prédéfinie.

A l'instant t₂, la troisième unité de calcul CUz détermine que chaque mémoire de réception 12a, 12b comporte une donnée stockée. En outre, aucune exécution de la troisième opération prédéfinie par la troisième unité de calcul CUz n'est en cours. La troisième unité de calcul déclenche donc une première exécution de la troisième opération prédéfinie z1 pour des données associées à la première voie.

A un instant t₃, la première unité de calcul CUx termine la deuxième exécution x2 de la première opération prédéfinie et transmet le résultat ainsi obtenu, éventuellement en association avec un identifiant de la deuxième voie, à la troisième unité de calcul CUz. La première unité de calcul CUx affecte alors la valeur prédéfinie à un signal de validité et transmet ledit signal de validité parallèlement et simultanément à la transmission du résultat. La troisième unité de calcul CUz détecte alors que le signal de validité reçu sur sa première entrée 10a est égal à la valeur prédéfinie. La mémoire de réception 12a associée à la première entrée 10a de la troisième unité de calcul CUz stocke alors ledit résultat, qui appartient à la deuxième voie. La première unité de calcul CUx détermine alors qu'aucune donnée n'est stockée dans sa mémoire de réception 12 et se met en attente d'une nouvelle donnée incidente.

A un instant t₄, la deuxième unité de calcul CUy termine la deuxième exécution y2 de la deuxième opération prédéfinie et transmet le résultat ainsi obtenu, éventuellement en association avec l'identifiant de la deuxième voie, à la deuxième entrée 10b de la troisième unité de calcul CUz. La deuxième unité de calcul CUy affecte alors la valeur prédéfinie à un signal de validité et transmet ledit signal de validité parallèlement et simultanément à la transmission du résultat. La troisième unité de calcul CUz détecte alors que le signal de validité reçu sur sa deuxième entrée 10b est égal à la valeur prédéfinie. La mémoire de réception 12b stocke alors ledit résultat, qui appartient à la deuxième voie. La troisième unité de calcul CUz détermine que chaque mémoire de réception 12a, 12b associée à l'une de ses entrées 10a, 10b comporte une donnée stockée. Toutefois, la première exécution z1 de la troisième opération prédéfinie étant en cours, la troisième unité de calcul CUz ne déclenche pas de nouvelle exécution de la troisième opération prédéfinie et se met en attente de la fin de la première exécution z1 de la troisième opération prédéfinie.

A un instant t₅, la troisième unité de calcul CUz termine la première exécution z1 de la troisième opération prédéfinie. La troisième unité de calcul CUz obtient ainsi le résultat de l'opération globale associé à la première voie et fournit ledit résultat en l'associant à l'identifiant de la première voie. En outre, la troisième unité de calcul CUz récupère dans chaque mémoire de réception 12a,12b, des données d'entrée de la deuxième voie et déclenche alors une deuxième exécution z2 de la troisième opération prédéfinie.

A un instant t₆, la troisième unité de calcul CUz termine la deuxième exécution z2 de la troisième opération prédéfinie, obtient le résultat de l'opération globale associé à la deuxième voie et fournit ledit résultat en l'associant à l'identifiant de la deuxième voie.

La **Fig. 6** illustre schématiquement un deuxième exemple d'un chronogramme représentant l'exécution d'une opération globale pour une première voie et une deuxième voie, par le flux de données du deuxième mode de réalisation.

Selon le deuxième exemple, les durées effectives d'exécution des première, deuxième et troisième opérations prédéfinies sont les mêmes que dans le premier exemple de chronogramme, décrit en Fig. 5. La troisième opération prédéfinie peut être exécutée sélectivement par la troisième unité de calcul CUza et par la quatrième unité de calcul CUzb.

Similairement au premier exemple de chronogramme, on considère, à l'instant initial t₀, que la mémoire de réception 12 de la première unité de calcul CUx comporte des données d'entrée appartenant à la première et à la deuxième voie, et que la mémoire de réception 12 de la deuxième unité de calcul CUy comporte des données d'entrée appartenant à la première et à la deuxième voie.

A l'instant t₀, similairement à ce qui est décrit en Fig. 5, une première exécution de la première opération prédéfinie est déclenchée par la première unité de calcul CUx et une première exécution de la deuxième opération prédéfinie est déclenchée par la deuxième unité de calcul CUy, pour des données appartenant à la première voie.

A l'instant t₁, la première unité de calcul CUx termine la première exécution x1 de la première opération prédéfinie et transmet le résultat ainsi obtenu, éventuellement en association avec l'identifiant de la première voie, à la première entrée 10a de la troisième unité de calcul CUza, de manière simultanée avec un signal de validité égal à la valeur prédéfinie. Ledit signal de validité égal à la valeur prédéfinie est détecté par la première entrée 10a de la troisième unité de calcul CUza Et ledit résultat est alors stocké dans la mémoire de réception 12a de la troisième unité de calcul CUza.

La première unité de calcul Cux déclenche en outre une deuxième exécution x2 de la première opération prédéfinie pour des données appartenant à la deuxième voie.

A l'instant t₂, la deuxième unité de calcul Cuy termine la première exécution y1 de la deuxième opération prédéfinie et transmet le résultat ainsi obtenu, éventuellement en association avec l'identifiant de la première voie, à la deuxième entrée 10b de la troisième unité de calcul CUza, de manière simultanée avec un signal de validité égal à la valeur prédéfinie. Ledit signal de validité égal à la valeur prédéfinie est détecté par la deuxième entrée 10b de la troisième unité de calcul CUza et ledit résultat est alors stocké dans la mémoire de réception 12b de la troisième unité de calcul CUza.

La troisième unité de calcul CUza déclenche alors une première exécution z1 de la troisième opération prédéfinie pour des données appartenant à la première voie, à partir des données stockées dans les mémoires de réception 12a et 12b de la troisième unité de calcul CUza.

La deuxième unité de calcul CUy déclenche en outre une deuxième exécution y2 de la deuxième opération prédéfinie à partir d'une donnée d'entrée de la deuxième voie.

A l'instant t₃, la première unité de calcul Cux termine la deuxième exécution x2 de la première opération prédéfinie et transmet le résultat ainsi obtenu, éventuellement en association avec l'identifiant de la deuxième voie, à la première entrée 10a de la quatrième unité de calcul Cuzb, de manière simultanée avec un signal de validité égal à la valeur prédéfinie. Ledit signal de validité égal à la valeur prédéfinie est détecté par la première entrée 10a de la quatrième unité de calcul CUzb et ledit résultat est stocké dans la mémoire de réception 12a de la quatrième unité de calcul Cuzb.

A l'instant t₄, la deuxième unité de calcul Cuy termine la deuxième exécution y2 de la deuxième opération prédéfinie et transmet le résultat ainsi obtenu, éventuellement en association avec l'identifiant de la deuxième voie, à la deuxième entrée 10b de la quatrième unité de calcul Cuzb, de manière simultanée avec un signal de validité égal à la valeur prédéfinie. Ledit signal de validité égal à la valeur prédéfinie est détecté par la deuxième entrée 10b de la quatrième unité de calcul CUzb et ledit résultat est stocké dans la mémoire de réception 12b de la quatrième unité de calcul CUzb.

En outre, la quatrième unité de calcul CUzb déclenche une deuxième exécution z2 de la troisième opération prédéfinie pour des données appartenant à la deuxième voie, à partir des données stockées dans les mémoires de réception 12a et 12b de la quatrième unité de calcul CUzb.

A l'instant t₅, la troisième unité de calcul CUza obtient le résultat de l'opération globale appartenant à la première voie et fournit ledit résultat en l'associant à l'identifiant de la première voie.

A un instant t₆', la quatrième unité de calcul CUzb obtient le résultat de l'opération globale appartenant à la deuxième voie et fournit ledit résultat en l'associant à l'identifiant de la deuxième voie.

L'instant t₆' intervient plus tôt que l'instant t₆ décrit à la Fig. 5 grâce à la duplication de la troisième unité de calcul CUz en une troisième et une quatrième unité de calcul CUza et CUzb identiques. Il est ainsi possible de minimiser la durée d'exécution de l'opération globale pour plusieurs voies.

Dans les premier et second exemples de chronogramme, chaque unité de calcul CUx, CUy, CUz, CUza, CUzb est à nouveau disponible pour exécuter son opération prédéfinie dès qu'un résultat appartenant à la deuxième voie est obtenu, et peut alors être utilisée pour d'autres voies par exemple. Ainsi, l'unité de calcul CUx est disponible dès l'instant t₃, l'unité de calcul CUy est disponible dès l'instant t₄ et l'unité de calcul CUz est disponible à l'instant t₆ tandis que l'unité de calcul CUza est disponible dès l'instant t₅ et que l'unité de calcul CUz est disponible dès l'instant t₆'.

## Revendications

1. Unité de calcul (CU, CUx, CUy, CUz, CUza, CUzb) d'un circuit intégré configurable, l'unité de calcul comportant :
- au moins une entrée (10, 10a, 10b), configurée pour recevoir des données incidentes,
- une sortie (11),
- un coeur (100) situé entre la au moins une entrée et la sortie et configuré pour exécuter une opération prédéfinie à partir d'au moins une donnée d'entrée afin d'obtenir un résultat, et pour transmettre le résultat obtenu vers la sortie (11),
l'unité de calcul (CU, CUx, CUy, CUz, CUza, CUzb) étant **caractérisée en ce qu'**elle comporte en outre :
- une mémoire tampon de type First In First Out, dite mémoire de réception (12, 12a, 12b), associée à chaque entrée (10, 10a, 10b) et configurée pour stocker chaque donnée incidente reçue par ladite entrée,
et **en ce que** l'unité de calcul (CU, CUx, CUy, CUz, CUza, CUzb) est configurée pour :
- détecter (211) un signal de validité reçu sur ladite au moins une entrée et déclencher (213) le stockage, par la mémoire de réception (12) associée à l'entrée en question, d'une donnée incidente lorsque le signal de validité détecté est égal à une valeur prédéfinie,
- transmettre au coeur (100), en tant que donnée d'entrée, une donnée stockée dans chaque mémoire de réception, et déclencher (203) une exécution de l'opération prédéfinie lorsqu'au moins une donnée est stockée dans chaque mémoire de réception de l'unité de calcul (201), et lorsqu'en outre aucune exécution de l'opération prédéfinie n'est en cours (202),
- transmettre sur la sortie un signal de validité égal à la valeur prédéfinie simultanément à la transmission de chaque résultat obtenu, et transmettre un signal de validité différent de la valeur prédéfinie sinon.

2. Unité de calcul selon la revendication 1, configurée en outre pour associer un identifiant à chaque résultat transmis, ledit identifiant étant un identifiant associé à la donnée incidente à partir de laquelle ledit résultat transmis est obtenu.

3. Unité de calcul selon la revendication 2, configurée de telle sorte que l'identifiant associé à chaque résultat transmis est concaténé avec le résultat transmis.

4. Unité de calcul selon l'une quelconque des revendications 1 à 3, configurée en outre de telle sorte qu'aucune exécution de l'opération prédéfinie n'est en cours lorsqu'une exécution immédiatement précédente de l'opération prédéfinie est terminée et que le résultat fourni par ladite exécution précédente est transmis vers la sortie (11).

5. Unité de calcul selon l'une quelconque des revendications 2 à 4, configurée de telle sorte que l'identifiant associé à chaque donnée incidente est un identifiant d'une voie à laquelle appartient ladite donnée incidente, une voie étant un ensemble de données utilisées par un ensemble d'unités de calcul pour obtenir un même résultat final à partir d'un jeu de données initial, et l'identifiant associé à chaque résultat transmis est l'identifiant de la voie à laquelle appartient le résultat.

6. Circuit intégré configurable comportant un ensemble d'unités de calcul (CU, CUx, CUy, CUz, CUza, CUzb) selon l'une quelconque des revendications 1 à 5, lesdites unités de calcul étant interconnectées entre elles selon une séquence prédéfinie, de telle sorte que, en considérant une première unité de calcul (CUx, CUy) dont la sortie (11) est connectée à une entrée (10, 10a, 10b) d'une deuxième unité de calcul (CUz, CUza, CUzb) qui suit la première unité de calcul (CUx, CUy) selon la séquence prédéfinie, le résultat et le signal de validité transmis par le coeur (100) vers la sortie (11) de la première unité de calcul (CUx, CUy) sont automatiquement transmis à l'entrée (10, 10a, 10b) de la deuxième unité de calcul (CUz, CUza, CUzb).

7. Circuit intégré configurable selon la revendication 6, dans lequel la connexion entre la sortie d'une unité de calcul et l'entrée de l'unité de calcul suivante selon la séquence prédéfinie est implémentée par un bus de communication configuré pour transmettre le résultat en association avec un identifiant et pour transmettre le signal de validité.

8. Aéronef (4) comportant un circuit intégré configurable selon la revendication 7.

9. Procédé implémenté par une unité de calcul (CU, CUx, CUy, CUz, CUza, CUzb) d'un circuit intégré configurable, l'unité de calcul (CU, CUx, CUy, CUz, CUza, CUzb) comportant :
- au moins une entrée (10, 10a, 10b), configurée pour recevoir des données incidentes,
- une sortie (11),
- un coeur (10) situé entre la au moins une entrée et la sortie et configuré pour exécuter une opération prédéfinie à partir d'au moins une donnée d'entrée afin d'obtenir un résultat, et pour transmettre le résultat obtenu vers la sortie (11),
le procédé étant **caractérisé en ce que**, l'unité de calcul (CU, CUx, CUy, CUz, CUza, CUzb) comportant en outre une mémoire tampon de type First In First Out, dite mémoire de réception (12, 12a, 12b), associée à chaque entrée (10, 10a, 10b) et configurée pour stocker chaque donnée incidente reçue par ladite entrée (10, 10a, 10b), le procédé comporte les étapes suivantes, implémentées par l'unité de calcul (CU, CUx, CUy, CUz, CUza, CUzb) :
- détecter (211) un signal de validité reçu sur ladite au moins une entrée et déclencher (213) le stockage, par la mémoire de réception associée à l'entrée en question, d'une donnée incidente lorsque le signal de validité détecté est égal à une valeur prédéfinie,
- transmettre au coeur (100), en tant que donnée d'entrée, une donnée stockée dans chaque mémoire de réception, et déclencher (203) une exécution de l'opération prédéfinie lorsqu'au moins une donnée est stockée dans chaque mémoire de réception de l'unité de calcul (201), et lorsqu'en outre aucune exécution de l'opération prédéfinie n'est en cours (202),
- transmettre sur la sortie un signal de validité égal à la valeur prédéfinie simultanément à la transmission de chaque résultat obtenu, et transmettre un signal de validité différent de la valeur prédéfinie sinon.
